# EUROPEAN PATENT SPECIFICATION

(11) **EP 3 886 156 B1**
(45) Date of publication and mention of the grant of the patent: **08.06.2022**
(21) Application number: 20165951.3
(22) Date of filing: 26.03.2020
(51) Int. Cl.: H01L 23/34, H01L 23/24, H01L 23/053, H01L 25/07, G01K 1/14, G01K 11/32, H01L 23/498, H01L 23/00, H01L 23/373

(54) **POWER SEMICONDUCTOR MODULE ARRANGEMENT AND METHOD OF FORMING SUCH AN ARRANGEMENT**
LEISTUNGSHALBLEITERMODULANORDNUNG UND FERTIGUNGSVERFAHREN EINER SOLCHEN ANORDNUNG
AGENCEMENT DE MODULE SEMI-CONDUCTEUR DE PUISSANCE ET MÉTHODE DE RÉALISATION D'UN TEL AGENCEMENT

(43) Date of publication of application: 29.09.2021
(73) Proprietor: Infineon Technologies AG, 85579 Neubiberg (DE)
(72) Inventor: ARENS, Andre, 59602 Ruethen (DE)
(74) Representative: Westphal, Mussgnug & Partner, Patentanwälte mbB

(56) References cited:
- EP-A1- 3 511 977
- WO-A2-2011/113443
- DE-A1-102007 052 630
- US-B2- 9 882 420

## Description

### TECHNICAL FIELD

The instant disclosure relates to a power semiconductor module arrangement, in particular to a power semiconductor module arrangement comprising at least one temperature sensor arrangement.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted onto the semiconductor substrate using soldering or sintering techniques.

During operation of the power semiconductor module arrangement, the controllable semiconductor elements may generate heat, e.g., during static operation while permanently conducting a current, or in consequence of performing switching processes. In order to prevent the power semiconductor module arrangement, and in particular the controllable semiconductor elements, from overheating, usually a temperature of the power semiconductor module arrangement is monitored. If a certain threshold temperature is exceeded, the power semiconductor module arrangement may be switched off, or switching operations may be performed at a lower speed until the temperature has dropped to below the temperature threshold.

Therefore, at least one temperature sensor (e.g., an NTC resistor, negative temperature coefficient resistor) may be coupled to the power semiconductor module arrangement. In particular, such temperature sensors are often mounted to a base plate of the arrangement. They can therefore usually only monitor the temperature of the base plate and may not be able to directly monitor the rise in temperature of the controllable semiconductor elements. This temperature rise is mostly calculated from the losses generated in the controllable semiconductor elements. Such temperature sensors usually comprise thermoelectric elements or platinum resistors, for example. With such sensors, it is often necessary to implement a galvanic isolation. Further, the temperature measurements may be negatively affected by electric or magnetic fields resulting from the operation of the controllable semiconductor elements. This may result in faulty measurements. A lack of isolation may result in the destruction of the controllable semiconductor elements. Even further, many sensors have a large thermal mass and are therefore not able to detect fast temperature changes. It is also critical to perform temperature measurements close to or on the controllable semiconductor elements or on high voltage conductor tracks of the arrangement.

Document WO 2011/113443 A2 discloses a sensor system for a power electronics module. The system comprises a optical fibre mounted inside the module housing and connected to an external sensor system. The optical fibre is arranged so that it lies proximate to one or more semiconductor dies within the housing, and can sense their temperature. The fibre can be connected to the die by glue, mechanical connection, or can in other examples be provided in the underlying support structure such as a DCB (direct copper bonded ceramic structure) or base plate. The fibre can contain an optical grating, such as an FBG or LPG, or can operate based on interferometry, to detect temperature or strain.

There is a need for a power semiconductor module arrangement comprising a temperature sensor arrangement that allows to reliably monitor even fast temperature changes of the power semiconductor module arrangement without harming the controllable semiconductor elements of the power semiconductor module arrangement.

### SUMMARY

A power semiconductor module arrangement according to independent claim 1 is disclosed, as well as a method of forming a power semiconductor module arrangement according to independent claim 12. Advantageous features are disclosed in the dependent claims.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a top view of a power semiconductor module arrangement according to one example.
Figure 3 is a cross-sectional view of a power semiconductor module arrangement according to one example.
Figure 4 schematically illustrates a detail of a sidewall of a power semiconductor module housing according to one example.
Figure 5 schematically illustrates the detail of Figure 4 with a sensor element protruding through the sidewall of the housing.
Figure 6 schematically illustrates one aspect of a temperature sensor according to an example.
Figure 7 schematically illustrates a temperature sensor arrangement according to one example.
Figure 8, including Figures 8A and 8B, schematically illustrates examples of a semiconductor body with a sensor element mounted thereto in greater detail.
Figure 9, including Figures 9A and 9B, schematically illustrates a method for forming an adhesive connection.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

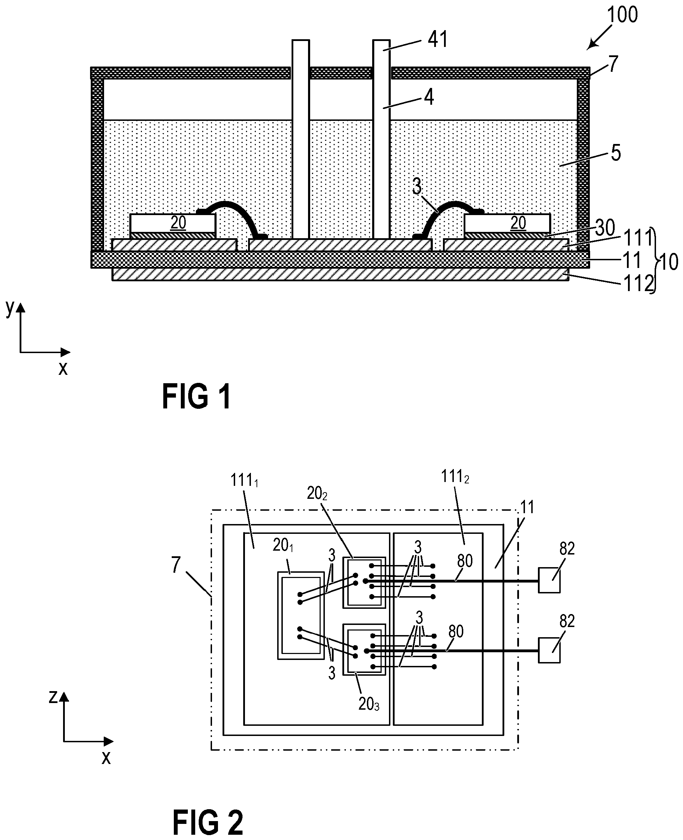

Referring to Figure 1, a cross-sectional view of a power semiconductor module arrangement 100 is illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si3N4. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This, however, is only an example. It is also possible that the housing 7 further comprises a ground surface and the semiconductor substrate 10 is arranged on the ground surface inside the housing 7. According to another example, the semiconductor substrate 10 may be mounted on a base plate. The base plate may form a bottom of the housing 7. In some power semiconductor module arrangements 100, more than one semiconductor substrate 10 is arranged within the same housing 7.

One or more semiconductor bodies 20 may be arranged on the at least one semiconductor substrate 10. Each of the semiconductor bodies 20 arranged on the at least one semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" in this context means that the first metallization layer 111 is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contacted from outside the housing 7 in any other suitable way. For example, terminal elements 4 may be arranged closer to or adjacent to the sidewalls of the housing 7. It is also possible that terminal elements 4 protrude vertically or horizontally through the sidewalls of the housing 7. It is even possible that terminal elements 4 protrude through a ground surface of the housing 7. The first end of a terminal element 4 may be electrically and mechanically connected to the semiconductor substrate 10 by an electrically conductive connection layer (not explicitly illustrated in Figure 1). Such an electrically conductive connection layer may be a solder layer, a layer of an electrically conductive adhesive, or a layer of a sintered metal powder, e.g., a sintered silver (Ag) powder, for example.

The power semiconductor module arrangement 100 generally further includes a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 41, however, are not covered by the casting compound 5 and protrude from the casting compound 5 through the housing 7 to the outside of the housing 7. The casting compound 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with a casting compound 5. In this case, the casting compound 5 may be a rigid material, for example.

At least some semiconductor bodies 20 of the power semiconductor module arrangement 100 generally perform a plurality of switching operations during the operation of the power semiconductor module arrangement 100. When performing many switching operations within a short period of time, the semiconductor bodies 20 generate heat which, in the worst case, may rise to a temperature above a certain maximum threshold. Further, heat may also be generated during static operation while permanently conducting a current. Temperatures above such a maximum threshold may adversely affect the operation of the power semiconductor module, or even lead to the total failure of one or more semiconductor bodies 20.

Therefore, a temperature of the power semiconductor module arrangement 100 is monitored. It may be possible to monitor a maximum temperature or, additionally or alternatively, to monitor a temperature cycle. Monitoring a temperature cycle allows to make predictions about the lifetime of the semiconductor bodies 20, or to discover a deterioration of the thermal resistance Rₜₕ, e.g., of the semiconductor bodies 20. The monitored temperature, for example, may be a temperature of one or more of the semiconductor bodies 20. If it is detected that the temperature exceeds a certain threshold, the power semiconductor module arrangement 100 may be switched off, or the switching frequency or output power may be reduced until the temperature has dropped to below the temperature threshold. Once the temperature has dropped below the threshold, normal operation of the power semiconductor module arrangement 100 may be resumed.

Therefore, the power semiconductor module arrangement 100 comprises at least one temperature sensor arrangement 80. This is schematically illustrated in the example illustrated in Figure 2. Figure 2 illustrates a top view of an exemplary power semiconductor module arrangement 100. As has been described above, the power semiconductor module arrangement 100 may comprise at least one semiconductor substrate comprising a dielectric insulation layer 11 and a first metallization layer 111. A second metallization layer 112 is not visible in the top view of Figure 2. The second metallization layer 112, however, may also be omitted. In the example illustrated in Figure 2, the first metallization layer 111 is a structured layer comprising a first section 111₁ and a second section 1112. A first semiconductor body 20₁, a second semiconductor body 202, and a third semiconductor body 20₃ are mounted on the first section 1111 of the first metallization layer 111.

The first semiconductor body 20₁ is electrically coupled to the second and third semiconductor bodies 20₂, 20₃ by means of electrical connections 3 such as bonding wires, or bonding ribbons, for example. The second and third semiconductor bodies 202, 20₃ are electrically coupled to the second section 1112 of the first metallization layer 111 by means of electrical connections 3 such as bonding wires, or bonding ribbons, for example. The arrangement illustrated in Figure 2 is merely an example. The first metallization layer 111 may comprise any number of sections. Any number of semiconductor bodies 20 may generally be arranged and electrically connected to the first metallization layer 111 in any other suitable way.

The arrangement in Figure 2 comprises two temperature sensor arrangements 80. Each of the two temperature sensor arrangement 80 is configured to detect a temperature of the power semiconductor module arrangement 100. Generally it is however possible that the power semiconductor module arrangement comprises only one or more than two temperature sensor arrangements 80. If the power semiconductor module arrangement 100 comprises more than one temperature sensor arrangement 80, each temperature sensor arrangement 80 may be configured to measure a temperature at a different measuring position than the other temperature sensor arrangements 80. For example, each temperature sensor arrangement 80 may be configured to monitor the temperature of a different one of the semiconductor bodies 20. That is, each temperature sensor arrangement 80 may be mounted to one of the semiconductor bodies 20 with a first end. The temperature sensor arrangements 80 may protrude out of the housing 7 of the power semiconductor module arrangement 100 and a second end of each of the temperature sensor arrangements 80 may be coupled to an external evaluation unit 82.

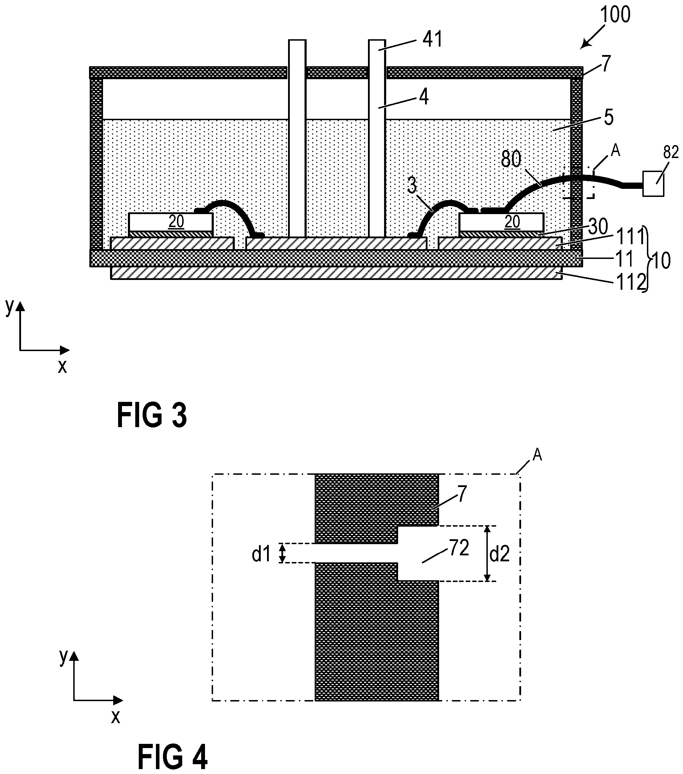

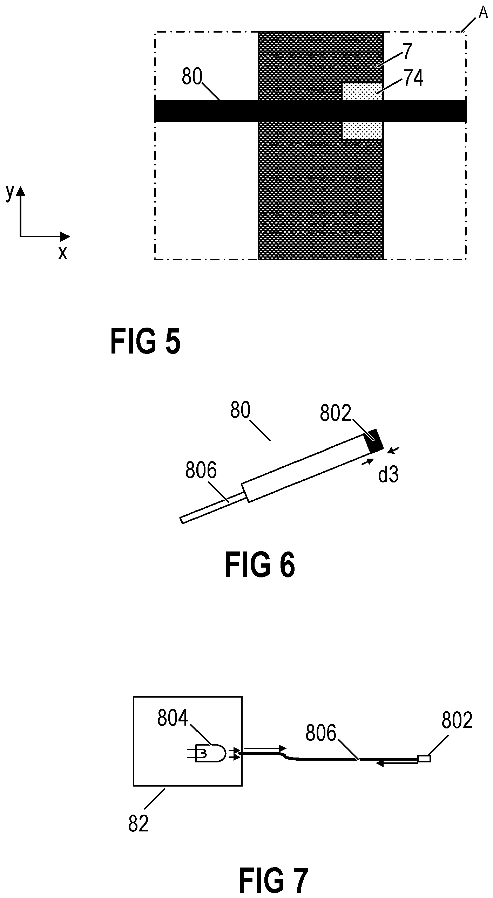

For example, each temperature sensor arrangement 80 may comprise a cable, e.g., a fibre optic cable that protrudes through a sidewall of the housing 7, as is schematically illustrated in the cross-sectional view of Figure 3. The sidewall of the housing 7, therefore, may comprise at least one hole or opening 72 through which a cable of a temperature sensor arrangement 80 may protrude. According to another example, the cable may protrude through a cover of the housing 7 instead of through the sidewall. It is also possible that in an arrangement comprising more than one temperature sensor arrangement 80, a first amount of cables protrudes through a sidewall, while a second amount of cables protrudes through a cover. A hole or opening 72 in a sidewall of the housing 7 is schematically illustrated in the detailed view A of Figure 4. According to one example, such an opening 72 may comprise a constant diameter throughout the sidewall of the housing 7. According to another example, however, as is exemplarily illustrated in Figure 4, the opening 72 may comprise different diameters. For example, the opening 72 may comprise a smaller first diameter d1 towards the inside of the housing 7, and a larger second diameter d2 towards the outside of the housing 7, or vice versa. The first diameter d1 may be between 1mm and 3mm, and the second diameter d2 may be between 3 mm and 5mm, for example. As is schematically illustrated in Figure 5, a cable of the temperature sensor arrangement 80 may extend through the opening 72 from the inside of the housing 7 to the outside. The same applies for a hole or opening in the cover of the housing 7.

As has been described above, the temperature sensor arrangement 80 may be mounted to a semiconductor body 20 or any other component of the power semiconductor module arrangement 100 inside the housing 7 the temperature of which is to be monitored with a first end. For example, the first end of the temperature sensor arrangement 80 may be mounted to the power semiconductor module arrangement 100 by means of an adhesive bond. According to one example, the adhesive bond comprises an adhesive or glue with or without ceramic fillers. This, however, is only an example. Generally, it is possible to mount the temperature sensor arrangement 80 on the power semiconductor module arrangement 100 in any suitable way. For example, any kind of mechanical connection is also possible. In order to prevent damaging the connection, and the first end from detaching from the power semiconductor module arrangement 100, the cable of the temperature sensor arrangement 80 may be fixed in position with regard to the housing 7 by means of a fixing element 74. The fixing element 74, for example, may comprise an adhesive material. According to one example, the adhesive material comprises an adhesive or glue with ceramic fillers. This, however, is only an example. Generally, it is possible to fix the temperature sensor arrangement 80 in position with regard to the housing 7 in any suitable way. For example, any kind of mechanical connection is also possible. If an adhesive material is used to fixate the temperature sensor arrangement in position with regard to the housing 7, the adhesive material may be electrically isolating, as to provide electrical isolation between the inside and the outside of the housing 7. For example, the larger second diameter d2 of the opening 72 may be filled with an adhesive material in order to hold the temperature sensor arrangement 80 in its position. In this way, even if a pulling of the cable or cord occurs outside the housing 7, the temperature sensor arrangement 80 is held in its desired position inside the housing 7. This may constantly ensure a sufficient mechanical and thermal contact between the temperature sensor arrangement 80 and the power semiconductor module arrangement 100. Additionally or alternatively, the fixing element 74 may comprise a bushing or sleeve, for example, that is arranged in the opening 72. If other fixing elements are used, electrical isolation between the inside and the outside of the housing 7 may be provided in any suitable way.

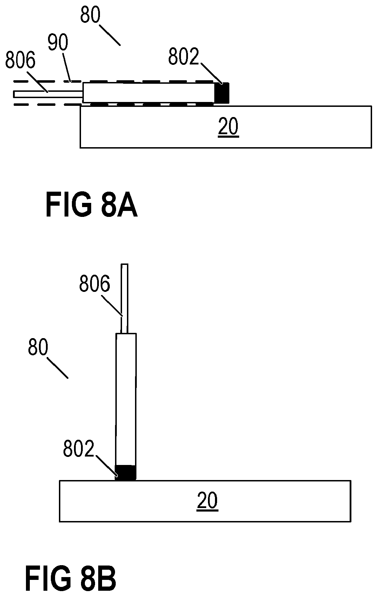

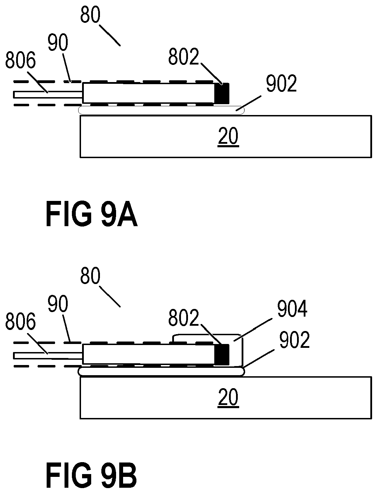

According to the present invention, a hollow tube 90 is first inserted through the sidewall or the cover of the housing 7 and mounted on the power semiconductor module arrangement 100 in a position the temperature of which is to be determined. The tube 90 is mounted on the power semiconductor module arrangement 100 and fixated to the sidewall or cover similar to what has been described for the temperature sensor arrangement 80 above. In this way, however, it is not necessarily the temperature sensor arrangement 80 itself which is (permanently) fixated to the power semiconductor module arrangement 100. The temperature sensor arrangement 80 can be easily inserted through the tube 90 from outside of the housing 7. In this way, the temperature sensor arrangement 80 can be easily brought into the correct position, but it is also possible to remove or replace the temperature sensor arrangement 80 very easily. For example, a temperature sensor arrangement 80 can be easily replaced if it is determined to be faulty. Such a tube 90 is schematically illustrated in Figures 8A and 9. The tube 90 is open at both ends such that a first end of the temperature sensor arrangement 80 protrude from one side of the tube 90 (see Figure 9) and a second end of the temperature sensor arrangement 80 protrude from the other end.

An exemplary temperature sensor arrangement 80 will now be described in further detail. Referring to the example illustrated in Figure 6, the temperature sensor arrangement 80 may be a fiber-optic sensor comprising an optically sensitive element 802 and an optical cable 806. The optical cable 806 may comprise an optical fiber. Light that is induced into the optical cable 806 passes along the optical cable 806 to the optically sensitive element 802, is reflected, and passes back along the optical cable 806 to an evaluation unit 82 (not illustrated in Figure 6). A more detailed view of an exemplary temperature sensor arrangement is schematically illustrated in Figure 7. For example, the evaluation unit 82 may comprise a data logger that is configured to collect, evaluate and store information about the determined temperatures.

In the example illustrated in Figure 7, the arrangement further comprises a light source 804 and an evaluation unit 82. The light source 804 may be any suitable light source that is capable of inducing light into the optical cable 806. The light source 804 may be integrated into the evaluation unit 82 or may be a separate unit. The optical cable 806 comprises a first end that is coupled to the optically sensitive element 802 and a second end. The second end may be coupled to the light source 804 and to the evaluation unit 82. The second end of the optical cable 806 may be arranged outside the housing 7 of a power semiconductor module arrangement 100, while the first end is arranged inside the housing 7 of the power semiconductor module arrangement 100.

The light generated by the light source 804 is induced into the optical cable 806. The light travels along the optical cable 806, gets reflected in the optically sensitive element 802, and travels back through the optical cable 806 to the evaluation unit 82. At least one characteristic of the light is altered if the temperature of the optical cable 806 and/or the optically sensitive element 802 changes. That is, the reflected light may be evaluated in the evaluation unit 82, and a temperature rise within the optical cable 806 and/or the optically sensitive element 802 may be determined based on a determined change of the at least one characteristic.

The optically sensitive element 802, as exemplarily illustrated in Figures 6 and 7, may have a length d3 of between 75µm and 125µm in prolongation of the optical cable 806, for example. That is, the dimensions of the optically sensitive element 802 may be comparably small. A cross-section of the optically sensitive element 802 may have a dimension of, e.g., width × height = 150µm × 150µm. This, however, is only an example. Any other suitable dimensions are also possible. For example, the dimensions width × height may be between 100µm × 100µm and 200µm × 200µm.

As the optically sensitive element 802 is attached to the power semiconductor module arrangement 100 at a position at which the temperature is to be measured, the temperature of the optically sensitive element 802 essentially corresponds to the temperature of the semiconductor module arrangement 100 at the measuring position. That is, for example, the temperature of the optically sensitive element 802 may essentially correspond to the temperature of a semiconductor body 20 which it is attached to.

The temperature sensor arrangement 80 does not necessarily require a galvanic isolation, as the temperature sensor arrangement 80 functions solely based on the transmission of light and no electric currents pass through the sensor, and in particular through the optically sensitive element 802 and the optical cable 806. However, electric isolation may be provided nonetheless by a connection layer that is used to mount the temperature sensor element 80 to the semiconductor module arrangement 100, for example. Further, the temperature sensor arrangement 80 as described herein does not induce any unwanted electric fields, magnetic fields or coupling effects. The temperature measurements further do not affect the operation of the semiconductor bodies 20 or of the whole power semiconductor module arrangement 100 in any way. Even further, the temperature sensor arrangement 80 generally has comparably small dimensions and a low thermal mass. A resulting measurement error generally is very small. Another advantage of a fiber optic temperature sensor 80 is the ability of being able to capture temperature changes very fast without any significant delays.

Now returning to the top view of Figure 2, the first end of a temperature sensor arrangement 80 may be attached, e.g., to a semiconductor body 20 in close proximity to at least one of the at least one electrical connection 3 attached thereto. In close proximity in this context means that the optically sensitive element 802 is attached to the semiconductor body 20 at a distance of less than 5mm or less than 2mm from at least one of the electrical connections 3. According to one example, the optically sensitive element 802 is attached to a semiconductor body 20 at a position between the connection points of two of the connection elements 3. The optically sensitive element 802 may be arranged as close to a top surface of the semiconductor body 20 as possible, with only a connection layer, e.g., a layer of adhesive material, arranged between the optically sensitive element 802 and the surface of the semiconductor body 20. The optically sensitive element 802 may be attached to the power semiconductor module arrangement 100 vertically or horizontally, for example. That is, the optical cable 806 may protrude from the semiconductor body 20 horizontally or essentially parallel to a top surface of the respective semiconductor body 20 (see, e.g., Figure 8A) or vertically or essentially perpendicular to a top surface of the respective semiconductor body 20 (see, e.g., Figure 8B), for example. According to one example, the optically sensitive element 802 of a temperature sensor arrangement 80 may be attached to the power semiconductor module arrangement 100 vertically and the optical cable 806 may protrude vertically from the semiconductor body 20, if the temperature sensor arrangement 80 is not arranged inside a tube 90. If, on the other hand, the temperature sensor arrangement 80 is arranged in a tube 90, as has been described above, the tube 90 and therefore the temperature sensor arrangement 80 may be attached to the power semiconductor module arrangement 100 horizontally and may protrude from the semiconductor body 20 in a horizontal direction which is essentially parallel to a top surface of the semiconductor body 20 and the semiconductor substrate 10. In any case, the optically sensitive element 802 may be arranged as close as possible to a top surface of the semiconductor body 20 such that it is in optimal thermal contact with the semiconductor body 20. As has been described above, a fixing element 74 configured to hold the optic temperature sensor arrangement 80 in position with regard to the housing 7 may provide strain relief for the first end of the optical cable 806 with the optically sensitive element 802 attached thereto. The fixing element 74 may hold the optical cable in its position with regard to the housing 7, without squeezing or crushing the optical cable 806, as a squeezing or crushing of the optical cable 806 could negatively affect the light conduction inside the cable 806.

An adhesive bond between the optically sensitive element 802 and the power semiconductor module arrangement 100 may be configured to provide a sufficiently good thermal coupling between the power semiconductor module arrangement 100 and the optically sensitive element 802. An adhesive bond may further be able to provide sufficient electric isolation even at high temperatures. An adhesive bond further provides a certain thermal stability such that it is able to withstand even high temperatures over the lifetime of the power semiconductor module arrangement 100. An adhesive bond further should not harm the components of the power semiconductor module arrangement 100 in any way. That is, an adhesive bond should not include any harmful or corrosive materials. The following demands may be placed on the adhesive material. On the surface and edges of the semiconductor bodies 20 (semiconductor chips) there are regions with differing voltage potentials that can be covered, in particular in the case of small chips, by the adhesive. The adhesive should therefore possess excellent isolation characteristics, also under high temperatures and over a long period of use. An adhesive layer between the top surface of the semiconductor body 20 and the temperature sensor arrangement 80 is decisive for the accuracy and dynamics of the temperature measurement. The adhesive should have very good thermal characteristics. This may be achieved, for example, by adding fillers to the adhesive. This adhesive layer may be applied to the semiconductor body 20 as thin as possible. The adhesive should also be able to withstand a constant temperature of 150°C and should be able to maintain sufficient adhesive strength at such temperatures. The temperature signal should not be altered by a pulling force exerted on the sensor wire. The adhesive should not damage the semiconductor body 20, neither while hardening nor while the semiconductor module is in operation. Furthermore, the hardness of the adhesive over temperature and time may be adjustable.

The adhesive that is used to fixate the temperature sensor arrangement 80 with respect to the sidewall or the cover of the housing 7 usually should also fulfill certain demands. Generally, it may be ensured that the adhesive strength between the casing of the optical fiber wire and the sidewall or cover of the (plastic) housing 7 is sufficient even at high temperatures. As the conduit for the wire is often located in the region of the module connection pin (terminal elements 4) or a base plate, the adhesive that is used to fixate the temperature sensor arrangement with respect to the sidewall or cover of the housing 7 may be highly insulating. During the installation process of the temperature sensor arrangement 80, in many cases it cannot be avoided that the semiconductor bodies 20 come into contact with the adhesive. Therefore, this adhesive should also not damage the semiconductor bodies 20.

According to one example, a temperature sensor arrangement 80 is coupled to a semiconductor body 20 by means of an adhesive layer. In order to form the adhesive layer, a first pre-layer 902 of adhesive material may be applied to the semiconductor body 20 (e.g., at room temperature) and the temperature sensor arrangement 80 may be arranged on the semiconductor body 20 such that its optically sensitive element 802 adjoins the first pre-layer 902 and is arranged as close as possible to the semiconductor body 20. The first pre-layer 902 of adhesive material may then be heated. For example, the first pre-layer 902 may be heated to a temperature of about 95°C for at least one hour. In this way, liquid may be removed from the first pre-layer 902 and the first pre-layer 902 may be hardened. Afterwards, a second pre-layer 904 of adhesive material may be applied such that it at least partly covers the previously applied and hardened first pre-layer 902. The second pre-layer 904, for example, may further cover at least parts of the temperature sensor arrangement 80. During the same step, adhesive material may be applied to the hole or opening 72 in the sidewall or cover of the housing 7 in order to fixate the temperature sensor arrangement 80 to the housing 7. A further heating step may follow, e.g., at temperatures of about 120°C for at least one hour during which the second pre-layer 904 and the adhesive material applied to the hole or opening 72 may be hardened. In this way, the temperature sensor arrangement 80 may be securely attached to the semiconductor body 20 and to the housing 7. The mentioned temperatures and times, however, are merely examples. Any other suitable temperature and times may be chosen in order to dry the adhesive material. Applying the adhesive material to the semiconductor body 20 in two separate steps reduces the stress on the top surface of the semiconductor body 20. The process described above is exemplarily illustrated in Figures 9A and 9B.

## Claims

1. A power semiconductor module arrangement (100) comprising:
a housing (7);
a semiconductor substrate (10) arranged inside the housing (7), said substrate (10) comprising a dielectric insulation layer (11), and a first metallization layer (111) arranged on a first side of the dielectric insulation layer (11);
at least one controllable semiconductor element (20) mounted on the first metallization layer (111) of the substrate (10);
at least one temperature sensor arrangement (80), each of the at least one temperature sensor arrangement (80) comprising an optically sensitive element (802) and an optical cable (806) coupled to the optically sensitive element (802) with a first end,
wherein
the first end of each optical cable (806) is arranged inside the housing (7);
each optical cable (806) extends from the inside of the housing (7) through a wall or cover of the housing (7) to the outside of the housing (7) such that the second end of each optical cable (806) is arranged outside the housing (7);
**characterized in**:
at least one tube (90) extending from the inside of the housing (7) through a wall or cover of the housing (7) to the outside of the housing (7), wherein:
each of the at least one temperature sensor arrangement (80) is arranged inside a different one of the at least one tube (90).

2. The power semiconductor module arrangement (100) of claim 1, wherein
each optically sensitive element (802) of the at least one temperature sensor arrangement (80) is attached and thermally coupled to the power semiconductor module arrangement (100) at a different mounting position; and
the second end of each optical cable (806) of the at least one temperature sensor arrangement (80) is configured to be coupled to a light source (804) and to an evaluation unit (82).

3. The arrangement of claim 1 or 2, wherein at least one characteristic of light induced into the optical cable (806) by the light source (804) changes as a function of temperature.

4. The arrangement of claim 3 further comprising at least one fixing element (74),
wherein each of the at least one fixing element (74) is configured to hold at least one of the at least one optical cable (806) in position with respect to the housing (7).

5. The arrangement of claim 4, wherein the fixing element (74) comprises an adhesive material.

6. The arrangement of any of the preceding claims, wherein each of the optically sensitive elements (802) of the at least one temperature sensor arrangement (80) is attached to the one of the controllable semiconductor elements (20) or to the substrate (10) by means of an adhesive bond.

7. The arrangement of claim 6, wherein each of the adhesive bonds comprises an adhesive material comprising fillers.

8. The arrangement of claim 6 or 7, wherein each of the adhesive bonds comprises
a first pre-layer (902) that is arranged between the respective temperature sensor arrangement (80) and the controllable semiconductor element (20) or substrate (10); and
a second pre-layer (904) which at least partly covers the first pre-layer (902) and which at least partly covers the temperature sensor arrangement (80).

9. The arrangement of any of claims 1 to 8, wherein at least one of the at least one temperature sensor arrangement (80) is attached and thermally coupled to one of the controllable semiconductor elements (20) with its first end, and wherein the optical cable (806) of the respective at least one temperature sensor arrangement (80) protrudes from the semiconductor body (20) essentially parallel to a top surface of the respective semiconductor body (20).

10. The arrangement of any of claims 1 to 9, wherein at least one of the at least one temperature sensor arrangement (80) is arranged inside one of the at least one tube (90) and is attached and thermally coupled to one of the controllable semiconductor elements (20) with its first end, and wherein the optical cable (806) of the respective at least one temperature sensor arrangement (80) protrudes from the semiconductor body (20) essentially perpendicular to a top surface of the respective semiconductor body (20).

11. The arrangement of any of the preceding claims, further comprising at least one electrical connection (3), wherein
each electrical connection (3) is electrically coupled to one of the at least one controllable semiconductor element (20) with a first end; and
at least one of the optically sensitive elements (802) of the at least one temperature sensor arrangement (80) is attached to one of the at least one controllable semiconductor element (20) in close proximity to at least one of the at least one electrical connection (3).

12. A method of forming a power semiconductor arrangement comprising:
providing a housing (7);
arranging a semiconductor substrate (10) inside the housing (7), said substrate (10) comprising a dielectric insulation layer (11), and a first metallization layer (111) arranged on a first side of the dielectric insulation layer (11);
mounting at least one controllable semiconductor element (20) on the first metallization layer (111) of the substrate (10);
mounting at least one temperature sensor arrangement (80) to the substrate (10) or to different ones of the at least one controllable semiconductor element (20), each of the at least one temperature sensor arrangement (80) comprising an optically sensitive element (802), and an optical cable (806) coupled to the optically sensitive element (802) with a first end, wherein
the first end of each optical cable (806) is arranged inside the housing (7);
each optical cable (806) extends from the inside of the housing (7) through a wall or cover of the housing (7) to the outside of the housing (7) such that the second end of each optical cable (806) is arranged outside the housing (7); **characterized in that**: at least one tube (90) extends from the inside of the housing (7) through a wall or cover of the housing (7) to the outside of the housing (7), wherein:
each of the at least one temperature sensor arrangement (80) is arranged inside a different one of the at least one tube (90).

13. The method of claim 12, wherein mounting at least one temperature sensor arrangement (80) to the substrate (10) or to different ones of the at least one controllable semiconductor element (20) comprises:
forming at least one first pre-layer (902) on the substrate (10) or on different ones of the at least one controllable semiconductor element (20);
arranging a first end of each of the at least one temperature sensor arrangement (80) on a different one of the at least one first pre-layer (902);
heating the at least one first pre-layer (902) in order to harden the at least one first pre-layer (902);
forming at least one second pre-layer (904) such that each of the at least one second pre-layer (904) at least partly covers a different one of the at least one previously applied and hardened first pre-layer (902), and such that it further covers at least parts of the respective temperature sensor arrangement (80) arranged on the respective ones of the at least one first pre-layer (902).

## Patentansprüche

1. Leistungshalbleitermodulanordnung (100), aufweisend:
ein Gehäuse (7);
ein Halbleitersubstrat (10), das innerhalb des Gehäuses (7) angeordnet ist, wobei das Substrat (10) eine dielektrische Isolierschicht (11) und eine erste Metallisierungsschicht (111) aufweist, die auf einer ersten Seite der dielektrischen Isolierschicht (11) angeordnet ist;
mindestens ein steuerbares Halbleiterelement (20), das auf der ersten Metallisierungsschicht (111) des Substrats (10) montiert ist;
mindestens eine Temperatursensoranordnung (80), wobei jede von der mindestens einen Temperatursensoranordnung (80) ein optisch sensitives Element (802) und ein optisches Kabel (806) aufweist, das mit einem ersten Ende an das optisch sensitive Element (802) gekoppelt ist,
wobei das erste Ende jedes optischen Kabels (806) innerhalb des Gehäuses (7) angeordnet ist;
jedes optische Kabel (806) sich von dem Inneren des Gehäuses (7) durch eine Wand oder Abdeckung des Gehäuses (7) hindurch zu der Außenseite des Gehäuses (7) erstreckt, so dass das zweite Ende von jedem optischen Kabel (806) außerhalb des Gehäuses (7) angeordnet ist;
**dadurch gekennzeichnet, dass**
mindestens ein Rohr (90) sich von dem Inneren des Gehäuses (7) durch eine Wand oder Abdeckung des Gehäuses (7) zu der Außenseite des Gehäuses (7) erstreckt, wobei:
jede von der mindestens einen Temperatursensoranordnung (80) innerhalb eines unterschiedlichen von dem mindestens einen Rohr (90) angeordnet ist.

2. Leistungshalbleitermodulanordnung (100) nach Anspruch 1, wobei
jedes optisch sensitive Element (802) der mindestens einen Temperatursensoranordnung (80) an einer unterschiedlichen Montageposition an der Leistungshalbleitermodulanordnung (100) befestigt und thermisch daran gekoppelt ist; und
das zweite Ende jedes optischen Kabels (806) der mindestens einen Temperatursensoranordnung (80) ausgestaltet ist, um an eine Lichtquelle (804) und eine Evaluierungseinheit (82) gekoppelt zu werden.

3. Anordnung nach Anspruch 1 oder Anspruch 2, wobei mindestens ein Charakteristikum des Lichts, das durch die Lichtquelle (804) in das optische Kabel (806) eingebracht wird, sich als Funktion der Temperatur ändert.

4. Anordnung nach Anspruch 3, des Weiteren aufweisend mindestens ein Fixierelement (74), wobei jedes von dem mindestens einen Fixierelement (74) ausgestaltet ist, um mindestens eines von dem mindestens einen optischen Kabel (806) in Bezug zu dem Gehäuse (7) in Position zu halten.

5. Anordnung nach Anspruch 4, wobei das Fixierelement (74) ein Klebstoffmaterial aufweist.

6. Anordnung nach einem der vorhergehenden Ansprüche, wobei jedes der optisch sensitiven Elemente (802) der mindestens einen Temperatursensoranordnung (80) an dem einen der steuerbaren Halbleiterelemente (20) oder dem Substrat (10) mittels einer Klebebindung befestigt ist.

7. Anordnung nach Anspruch 6, wobei jede der Klebebindungen ein Klebstoffmaterial aufweist, das Füllstoffe aufweist.

8. Anordnung nach Anspruch 6 oder 7, wobei jede der Klebebindungen aufweist:
eine erste Vorschicht (902), die zwischen der jeweiligen Temperatursensoranordnung (80) und dem steuerbaren Halbleiterelement (20) oder Substrat (10) angeordnet ist; und
eine zweite Vorschicht (904), die mindestens teilweise die erste Vorschicht (902) bedeckt und die mindestens teilweise die Temperatursensoranordnung (80) bedeckt.

9. Anordnung nach einem der Ansprüche 1 bis 8, wobei mindestens eine von der mindestens einen Temperatursensoranordnung (80) mit ihrem ersten Ende an einem der steuerbaren Halbleiterelemente (20) befestigt und thermisch an dieses gekoppelt ist, und wobei das optische Kabel (806) der jeweiligen mindestens einen Temperatursensoranordnung (80) von dem Halbleiterkörper (20) im Wesentlichen parallel zu der Deckfläche des jeweiligen Halbleiterkörpers (20) vorspringt.

10. Anordnung nach einem der Ansprüche 1 bis 9, wobei mindestens eine von der mindestens einen Temperatursensoranordnung (80) innerhalb von einem von dem mindestens einen Rohr (90) angeordnet ist und mit ihrem ersten Ende an einem der steuerbaren Halbleiterelemente (20) befestigt und thermisch an dieses gekoppelt ist, und wobei das optische Kabel (806) der jeweiligen mindestens einen Temperatursensoranordnung (80) von dem Halbleiterkörper (20) im Wesentlichen senkrecht zu der Deckfläche des jeweiligen Halbleiterkörpers (20) vorspringt.

11. Anordnung nach einem der vorhergehenden Ansprüche, des Weiteren aufweisend mindestens eine elektrische Verbindung (3), wobei
jede elektrische Verbindung (3) mit einem ersten Ende elektrisch an mindestens eines von dem mindestens einen steuerbaren Halbleiterelement (20) gekoppelt ist; und
mindestens eines der optisch sensitiven Elemente (802) der mindestens einen Temperatursensoranordnung (80) an einem von dem mindestens einen steuerbaren Halbleiterelement (20) in enger Nähe zu mindestens einer von der mindestens einen elektrischen Verbindung (3) befestigt ist.

12. Verfahren zum Bilden einer Leistungshalbleiteranordnung, aufweisend:
Bereitstellen eines Gehäuses (7);
Anordnen eines Halbleitersubstrats (10) innerhalb des Gehäuses (7), wobei das Substrat (10) eine dielektrische Isolierschicht (11) und eine erste Metallisierungsschicht (111) aufweist, die auf einer ersten Seite der dielektrischen Isolierschicht (11) angeordnet ist;
Montieren von mindestens einem steuerbaren Halbleiterelement (20) auf der ersten Metallisierungsschicht (111) des Substrats (10);
Montieren von mindestens einer Temperatursensoranordnung (80) auf dem Substrat (10) oder auf unterschiedlichen von dem mindestens einen steuerbaren Halbleiterelement (20), wobei jede von der mindestens einen Temperatursensoranordnung (80) ein optisch sensitives Element (802) und ein optisches Kabel (806) aufweist, das mit einem ersten Ende an das optisch sensitive Element (802) gekoppelt ist, wobei das erste Ende jedes optischen Kabels (806) innerhalb des Gehäuses (7) angeordnet ist;
jedes optische Kabel (806) sich von dem Inneren des Gehäuses (7) durch eine Wand oder Abdeckung des Gehäuses (7) hindurch zu der Außenseite des Gehäuses (7) erstreckt, so dass das zweite Ende von jedem optischen Kabel (806) außerhalb des Gehäuses (7) angeordnet ist;
**dadurch gekennzeichnet, dass**:
mindestens ein Rohr (90) sich von dem Inneren des Gehäuses (7) durch eine Wand oder Abdeckung des Gehäuses (7) zu der Außenseite des Gehäuses (7) erstreckt, wobei:
jede von der mindestens einen Temperatursensoranordnung (80) innerhalb eines anderen von dem mindestens einen Rohr (90) angeordnet ist.

13. Verfahren nach Anspruch 12,
wobei Montieren der mindestens einen Temperatursensoranordnung (80) an dem Substrat (10) oder an unterschiedlichen von dem mindestens einen steuerbaren Halbleiterelement (20) aufweist:
Bilden von mindestens einer ersten Vorschicht (902) auf dem Substrat (10) oder auf unterschiedlichen von dem mindestens einen steuerbaren Halbleiterelement (20) ;
Anordnen eines ersten Endes von jeder von der mindestens einen Temperatursensoranordnung (80) auf einer anderen von der mindestens einen Vorschicht (902) ;
Erwärmen der mindestens einen ersten Vorschicht (902), um die mindestens eine erste Vorschicht (902) zu härten;
Bilden von mindestens einer zweiten Vorschicht (904), so dass jede von der mindestens einen zweiten Vorschicht (904) mindestens teilweise eine unterschiedliche von der mindestens einen zuvor aufgebrachten und gehärteten ersten Vorschicht (902) bedeckt, und so, dass sie des Weiteren mindestens Teile der jeweiligen Temperatursensoranordnung (80) bedeckt, die auf jeweiligen von der mindestens einen ersten Vorschicht (902) angeordnet ist.

## Revendications

1. Agencement (100) de module à semiconducteur de puissance comprenant :
un boîtier (7) ;
un substrat (10) de semiconducteur disposé à l'intérieur du boîtier (7), le substrat (10) comprenant une couche (11) diélectrique isolante et une première couche (111) de métallisation disposée sur une première face de la couche (11) diélectrique isolante ;
au moins un élément (20) à semiconducteur pouvant être commandé et monté sur la première couche (111) de métallisation du substrat (10) ;
au moins un agencement (80) de capteur de température, chacun du au moins un agencement (80) de capteur de température comprenant un élément (802) sensible optiquement et un câble (806) optique relié à l'élément (802) sensible optiquement par un premier bout, dans lequel
le premier bout de chaque câble (806) optique est disposé à l'intérieur du boîtier (7) ;
chaque câble (806) optique s'étend de l'intérieur du boîtier (7) à l'extérieur du boîtier (7) en traversant une paroi ou un couvercle du boîtier (7), de manière à ce que le second bout de chaque câble (806) optique soit disposé à l'extérieur du boîtier (7) ;
**caractérisé par** :
au moins un tube (90) s'étendant de l'intérieur boîtier (7) à l'extérieur boîtier (7) en passant à travers une paroi ou un couvercle du boîtier (7), dans lequel :
chacun du au moins un agencement (80) de capteur de température est disposé à l'intérieur d'un tube différent du au moins un tube (90) .

2. Agencement (100) de module à semiconducteur de puissance suivant la revendication 1, dans lequel
chaque élément (802) sensible optiquement du au moins un agencement (80) de capteur de température est fixé et couplé thermiquement à l'agencement (100) de module à semiconducteur de puissance en une position de montage différente ; et
le deuxième bout de chaque câble (806) optique du au moins un agencement (80) de capteur de température est configuré pour être couplé à une source (804) lumineuse et à une unité (82) d'évaluation.

3. Agencement suivant la revendication 1 ou 2, dans lequel au moins une caractéristique de la lumière induite dans le câble (806) optique par la source (804) lumineuse change en fonction de la température.

4. Agencement suivant la revendication 3, comprenant en outre au moins un élément (74) de fixation,
dans lequel chacun du au moins un élément (74) de fixation est configuré pour maintenir au moins l'un du au moins un câble (806) optique en position par rapport au boîtier (7).

5. Agencement suivant la revendication 4, dans lequel l'élément (74) de fixation comprend une matière adhésive.

6. Agencement suivant l'une quelconque des revendications précédentes, dans lequel chacun de la pluralité d'éléments (802) sensibles optiquement du au moins un agencement (80) de capteur de température est fixé au un des éléments (20) à semiconducteur pouvant être commandés ou au substrat (10) au moyen d'une liaison adhésive.

7. Agencement suivant la revendication 6, dans lequel chacune des liaisons adhésives comprend une matière adhésive comprenant des charges.

8. Agencement suivant la revendication 6 ou 7, dans lequel chacune des liaisons adhésives comprend
une première pré-couche (902), qui est disposée entre l'agencement (80) respectif de capteur de température et l'élément (20) à semiconducteur pouvant être commandé ou le substrat (10) ; et
une deuxième pré-couche (904), qui recouvre au moins en partie la première pré-couche (902) et qui recouvre au moins en partie l'agencement (80) de capteur de température.

9. Agencement suivant l'une quelconque des revendications 1 à 8, dans lequel au moins l'un du au moins un agencement (80) de capteur de température est fixé et couplé thermiquement à l'un des éléments (20) à semiconducteur pouvant être commandé par son premier bout, et dans lequel le câble (806) optique du au moins un agencement (80) respectif de capteur de température fait saillie du corps (20) à semiconducteur essentiellement parallèlement à une surface de sommet du corps (20) respectif à semiconducteur.

10. Agencement suivant l'une quelconque des revendications 1 à 9, dans lequel au moins l'un du au moins un agencement (80) de capteur de température est disposé à l'intérieur de l'un du au moins un tube (90) et est fixé et couplé thermiquement à l'un des éléments (20) à semiconducteur pouvant être commandés par son premier bout, et dans lequel le câble (806) optique du au moins un agencement (80) respectif de capteur de température fait saillie du corps (20) à semiconducteur essentiellement perpendiculairement à une surface de sommet du corps (20) respectif à semiconducteur.

11. Agencement suivant l'une quelconque des revendications précédentes, comprenant en outre au moins une connexion (3) électrique, dans lequel
chaque connexion (3) électrique est connectée électriquement à l'un du au moins un élément (20) à semiconducteur pouvant être commandé par un premier bout ; et
au moins l'un des éléments (802) sensibles optiquement du au moins un agencement (80) de capteur de température est fixé à l'un du au moins un élément (20) à semiconducteur pouvant être commandé à proximité immédiate d'au moins l'une de la au moins une connexion (3) électrique.

12. Procédé de formation d'un agencement à semiconducteur de puissance, dans lequel :
on se procure un boîtier (7) ;
on met un substrat (10) de semiconducteur à l'intérieur du boîtier (7), le substrat (10) comprenant une couche (11) diélectrique isolante et une première couche (111) de métallisation disposée sur une première face de la couche (11) diélectrique isolante ;
on monte au moins un élément (20) à semiconducteur pouvant être commandé sur la première couche (111) de métallisation du substrat (10) ;
on monte au moins un agencement (80) de capteur de température sur le substrat (10) ou sur des éléments différents du au moins un élément (20) à semiconducteur pouvant être commandé, chacun du au moins un agencement (80) de capteur de température comprenant un élément (802) sensible optiquement et un câble (806) optique couplé à l'élément (802) sensible optiquement par un premier bout, dans lequel
le premier bout de chaque câble (806) optique est disposé à l'intérieur du boîtier (7) ;
chaque câble (806) optique s'étend de l'intérieur du boîtier (7) à l'extérieur du boîtier (7) en traversant une paroi ou un couvercle du boîtier (7), de manière à ce que le second bout de chaque câble (806) optique soit disposé à l'extérieur du boîtier (7), **caractérisé en ce que**
au moins un tube (90) s'étend de l'intérieur du boîtier (7) à l'extérieur du boîtier (7) en traversant une paroi ou un couvercle du boîtier (7), dans lequel :
chacun du au moins un agencement (80) de capteur de température est disposé à l'intérieur d'un tube différent du au moins un tube (90) .

13. Procédé suivant la revendication 12,
dans lequel monter au moins un agencement (80) de capteur de température sur le substrat (10) ou sur des éléments différents du au moins un élément (20) à semiconducteur pouvant être commandé comprend :
former au moins une première pré-couche (902) sur le substrat (10) ou sur des éléments différents du au moins un élément (20) à semiconducteur pouvant être commandé ;
disposer un premier bout de chacun du au moins un agencement (80) de capteur de température sur une pré-couche différente de la au moins une première pré-couche (902) ;
chauffer la au moins une première pré-couche (902) afin de durcir la au moins une première pré-couche (902) ;
former au moins une deuxième pré-couche (904), de manière à ce que chacune de la au moins une deuxième pré-couche (904) recouvre au moins en partie une pré-couche différente de la au moins une première pré-couche (902) appliquée précédemment et durcie, et de manière à ce qu'elle recouvre en outre au moins des parties de l'agencement (80) respectif de capteur de température disposé sur les pré-couches respectives de la au moins une première pré-couche (902) .
